# EUROPEAN PATENT APPLICATION

(11) **EP 2 323 230 A1**
(43) Date of publication of application: **18.05.2011**
(21) Application number: 09794328.6
(22) Date of filing: 26.06.2009
(51) Int. Cl.: H01S 3/106, H01S 3/06, H01S 3/094

(54) **WIDE-BAND WAVELENGTH-VARIABLE LASER DEVICE**

(30) Priority: 08.07.2008 JP 2008177496; 12.11.2008 JP 2008289340; 15.06.2009 JP 2009142411
(71) Applicant: Central Glass Company, Limited, Yamaguchi 755-0001 (JP)
(72) Inventor: OKAMOTO, Hideyuki, c/o Chemical Research Center, Kawagoe-shi, Saitama 350-1151 (JP); KUBOTA, Yoshinori, c/o Chemical Research Center, Kawagoe-shi, Saitama 350-1151 (JP); KASUGA, Ken, c/o Chemical Research Center, Kawagoe-shi, Saitama 350-1151 (JP); HARA, Ikunari, c/o Chemical Research Center, Kawagoe-shi, Saitama 350-1151 (JP)
(74) Representative: Manitz, Finsterwald & Partner GbR
(86) International application number: PCT/JP2009/061681
(87) International publication number: WO 2010/004882

(57) **Abstract**

In a laser apparatus including an excitation light source and a resonator in which a laser medium is disposed between optical paths of a first mirror reflecting light in a desired wavelength band and a second mirror and a first wavelength selecting means is disposed between optical paths of the laser medium and the second mirror, there is provided a wavelength-variable laser apparatus capable of continuously varying the laser oscillation wavelength by using at least a Pr³⁺-doped fluoride glass in the laser medium.

## Description

### TECHNICAL FIELD

The present invention relates to a wide-band wavelength-variable or tunable laser device or apparatus.

### BACKGROUND ART

In recent years, by the use of technique of wavelength conversion using nonlinear optical crystal etc. , it becomes possible to obtain laser from the UV light region to the infrared region.
For example, it is known that a laser light having a wavelength of 193nm equaling the wavelength of ArF laser can be obtained by generating a fourth harmonic wave of Ti sapphire laser by laser oscillation at a wavelength of 772 nm (patent document 1). Moreover, it is known that difference frequency mixing of Nd : YAG laser and Ti : Al2O6 (Ti sapphire) laser makes it possible to obtain a difference frequency light of 3.2 µm∼20µm (patent document 2).

In the case of generation of a laser light of a desired wavelength by the wavelength conversion technique as mentioned above, in order to realize a wavelength variable or tunable light source capable of wideband oscillation, it is desirable to achieve a capability of varying an oscillation wavelength of a fundamental wave laser as wide as possible. To this end, it is required to select a laser medium having a wide band gain and to form a resonator of a lower loss.

However, the laser medium generally used, having a crystal structure, is not suitable for wide band oscillation, and an optimum laser medium is not found yet.

In the case of a laser medium having a glass structure, by contrast, each of constituent atoms can assume a more random ligand field, and hence light generation of wider band is feasible. Moreover, as compared to silica glass or quartz glass of covalent bonding, fluoride glass of ionic bonding is greater in stark splitting, and has a capability of generating light in a wider range. For example, laser oscillation using Pr³⁺-doped fluoride glass fiber is confirmed at wavelength at which the gain forms a peak (491 nm, 520nm, 605nm, 635nm)(non-patent document 1, patent document 3). Moreover, by the use of Pr³⁺-doped fluoride glass fiber excited with Ar⁺ laser having a wavelength of 476.5nm, laser oscillation is confirmed discretely in ranges of 601 ∼618nm, 631∼641 nm, 690-703nm and 707-725nm as confirmed by j. Y. Allain et al. (non-patent document 2). However, since the excitation (3H₄ → 3P₀) with light having a wavelength of 476.5nm is direct excitation to emission upper level, the stimulated emission of (3P₀p → 3H₄) is generated by the excitation light itself, and hence the population inversion is difficult to attain.

Furthermore, laser oscillation is achieved around 491 nm, 521 nm and 635nm by direct excitation of (3H₄ → 3P₁, 3P₂) by the use of Pr³⁺ -doped fluoride glass fiber excited by blue semiconductor laser (as reported by non-patent document 3, patent document 4). However, a wide oscillation characteristic over the blue region and green region is not shown.

### PRIOR ART LITERATURE

### Patent Documents

- Patent Document 1:: JP2001-230478 A
- Patent Document 2:: JP 1 992(H04)-116170 U
- Patent Document 3;: JP 1 994(H06)-507045A
- Patent Document 4:: JP 2007-1 57764A

### Non-Patent Documents

Non-patent Document 1: Smart, R.G.,Hanna, D.C., Tropper, A.C., Davey, S.T., Carter, S.F., Szebesta, D.'CW room temperature Upconversion lasing at blue, green and red wavelengths in infrared-pumped Pr3+-doped fluoride fibre' , Electronics Letters, 1991 Page(s):1 1307-1309.
Non-patent Document 2: Allain, J.Y.; Monerie, M.; Poignant, H.,' Tunable CW lasing around 610, 635, 695, 715, 885 and 910 nm in praseodymium-doped fluorozirconate fibre' , Electronics Letters, 1991, Page(s):189-191
Non-patent Document 3: WEICHMANN, U., BAIER, J., BENGOECHEA, J., and MOENCH, H. :'GaN-diode pumped Pr3+:ZBLAN fiber-lasers for the visible wavelength range', Proc.CLEO/Europe-IQEC, European Conference on., Munich, Germany, 2007

### SUMMARY OF THE INVENTION

In a wide range wavelength-variable or tunable light source, discretely distributed variable wavelength ranges are reported in wavelength ranges of 601 ∼61 8nm, 631∼641 nm, 690-703nm, 707∼725nm, as mentioned above. However, there is not yet found a laser apparatus capable of continuously varying the laser oscillation wavelength over a still wider range.

It is an object of the present invention to provide a wide range wavelength-variable or tunable laser apparatus in a wide range including regions of blue, green, orange - deep red and near-infrared.

According to the present invention there is provided, in a laser apparatus comprising: an excitation light source comprising a GaN based laser diode having a wavelength range of 420∼475nm; and a resonator comprising a laser medium configured to emit light by excitation light from the excitation light source and disposed in the optical path between a first mirror allowing transmission of the excitation light from the excitation light source and reflecting light in a desired wavelength band excluding the excitation light and a second mirror reflecting light in a or the desired wavelength band, and a first wavelength selecting means disposed in the optical path between the laser medium and the second mirror;
a wavelength-variable laser apparatus (first apparatus) which is characterized in that the wavelength-variable laser apparatus can vary a laser oscillation wavelength continuously by using at least a Pr³+-doped fluoride glass as the laser medium.

The first apparatus may be a wavelength-variable laser apparatus (second apparatus) wherein the first wavelength selecting means includes one of a prism, an etalon, a birefringent filter, a dielectric multilayer film filter and a grating.

The first apparatus may be a wavelength-variable laser apparatus (third apparatus) wherein the laser medium forms a core portion of an optical waveguide.

The third apparatus may be a wavelength-variable laser apparatus (fourth apparatus) wherein both ends of the laser medium are connected, respectively, with optical waveguides of silica-based glass.

One of the first to fourth apparatus may be a wavelength-variable laser apparatus (fifth apparatus) wherein pulsed light is generated by disposing a dispersion compensating device for compensating for wavelength dispersion of the resonator as a whole, between of the laser medium and the optical path of the second mirror.

The fifth apparatus may be a wavelength-variable laser apparatus (sixth apparatus), wherein the dispersion compensating device is a second wavelength selecting means paired with the first wavelength selecting means.

### BRIEF DESCRIPTION OF THE DRAWINGS

FIG. 1 is a view showing, as an example, a wavelength-variable laser apparatus according to the present invention.
FIG. 2 is a view showing an example of a level structure making it possible to widen the band of a light source.
FIG. 3 is a view showing, as an example, a wavelength-variable laser apparatus according to the present invention.
FIG. 4 is a view showing a level structure of Pr³⁺ ion.
FIG. 5 is a view showing a structure of a wavelength-variable laser apparatus in a practical example 1, and practical examples 3-5.
FIG. 6 is a view showing an oscillation spectrum obtained by output monitoring of the practical example 1.
FIG. 7 is a view showing a structure of a wavelength-variable laser apparatus in a practical example 2.
FIG. 8 is a view showing an oscillation spectrum obtained by output monitoring of the practical example 2.
FIG. 9 is a view showing an oscillation spectrum obtained by output monitoring of the practical example 3.
FIG. 10 is a view showing an oscillation spectrum obtained by output monitoring of the practical example 4.
FIG. 11 is a view showing an oscillation spectrum obtained by output monitoring of the practical example 5.
FIG. 12 is a view showing a structure of a wavelength-variable laser apparatus of a practical example 6.

### DETAILED DESCRIPTION

A wideband wavelength-variable laser capable of continuously scanning the wavelength can be provided by the present invention.

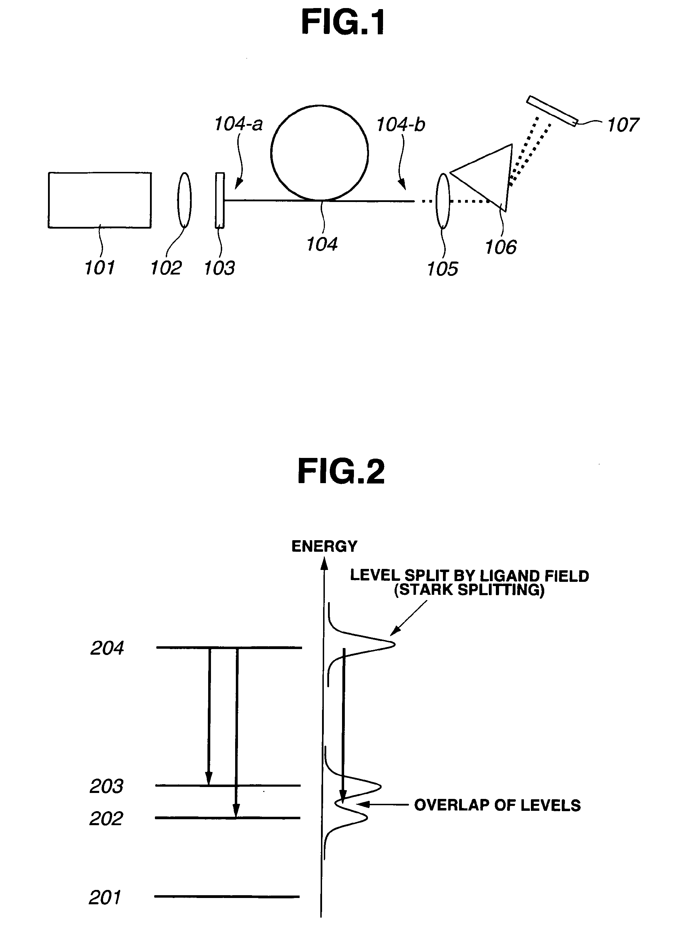

FIG. 1 shows an example according to the present invention. The system of FIG. 1 includes an excitation light source 101, a condensing or collecting lens 102, an excitation light transmission/laser light reflection filter 103, a rare earth doped fluoride glass fiber 104, a collimator lens 105, a prism 106, and a movable mirror 107. The excitation light irradiated from excitation light source 101 is condensed by condensing lens 102, and coupled to rare earth doped laser fiber 104. A excitation light source side fiber end 1 04-a on the excitation light source side is polished perpendicularly so as to form a right angle, and attached tightly to a surface of the excitation light transmission/laser light reflection filter 103. A fiber end 104-b on the side opposite to the excitation light source side is polished obliquely at an angle greater than or equal to 8° to suppress Fresnel reflection. The excitation light passes through the excitation light transmission/laser light reflection filter 103 without loss. A spontaneous emission light (ASE) generated in the fiber 104 is collimated by collimator lens 105, separated according to the wavelength by prism 106, and reflected by movable mirror 107. The generated ASE light reciprocates in a resonator formed by the excitation light transmission/laser light reflection filter 103 and movable mirror 107, and thereby induces laser oscillation.

Condensing lens 102 is preferably provided with an antireflection film to the excitation laser wavelength, and the collimator lens 105 and prism 106 are preferably provided with an antireflection film to the laser oscillation wavelength. Prism 106 need not be a triangular prism. Prism 106 may be in the form in which an incidence plane and an exit plane are cut to form a Brewster's angle with respect to the optical axis. Although the prism is used as a first wavelength selecting means, it is optional to use etalon, birefringent filter, grating or dielectric multilayer film filter.

In the case of obtaining an output of laser, it is optional to enable partial transmission by lowering the reflectivity at the laser wavelength, of the excitation light transmission/laser light reflection filter 103 or movable mirror 107, or to interpose a tap filter between optical paths in the resonator.

In the case of varying the oscillation wavelength, the object can be achieved by scanning the incident angle or the reflection angle by rotation of prism 106 or movable mirror 107, and feeding back only light of a desired wavelength to the fiber 104.

FIG. 2 shows an example of a level structure of a rare earth element in a fluoride glass used for wide band laser oscillation according to the present invention. In FIG. 2, there are shown an upper level 204 of laser, different lower levels 203 and 204 of laser oscillation close to each other, and a ground level 201. Fluoride glass is glass of the ionic bonding, likely to take a free atomic configuration as compared to crystal and silica glass material of the covalent bond, and hence the width of stark splitting is greater. Therefore, two adjacent levels in fluoride glass have an overlap, and are capable of behave as a continuous single level, specifically in a laser oscillation system having a smaller resonator loss. In the above explanation, the lower levels of the laser oscillation are adjacent to each other. However, a wide band laser oscillation characteristic is obtained also in the case of two upper levels which are different in laser oscillation and which are adjacent to each other, because two adjacent upper levels can behave as a continuous single upper level as in the case of two adjacent lower levels.

Furthermore, a laser oscillation characteristic of a wider band is obtained when a plurality of upper levels or lower levels are close to one another.

In order to obtain a widest band laser oscillation characteristic, use is made of fluoride glass doped with Pr³⁺, as laser medium.

To excite Pr3+ efficiently, the range of excitation wavelength is required to be contained in the range of 420∼475nm. A more desirable range is 430-473nm though it is not possible to determine or stipulate the range totally unconditionally since the desirable range is dependent on the type of glass. A still more desirable range is 435∼455nm, in which the absorption coefficient is high.

Thus, according to the invention, the wavelength variation range or variable wavelength range is expanded since the population inversion is easier by excitation of Pr³⁺ with a characteristic wavelength.

For example, in the case of obtaining a wideband wavelength varying characteristic with an amplification medium doped with Pr³⁺, it is possible to vary the oscillation wavelength continuously around the wavelength range of 470-500nm, by using transition of (³P₁, ³P₀) → ³H₄.
Moreover, it is possible to vary the oscillation wavelength continuously around the wavelength range of 590-750nm, by using transition of ³P₁ →³H₆, ³P₀ → (³H₆, ³F₂), ³P₁ → ³F₃, ³P₀ → (³F₃, ³F₄), and/or ³P₁ → ³F₄.
Moreover, it is possible to vary the oscillation wavelength continuously around the wavelength range of 510∼5 50nm, by using transition of (³P₁, ³P₀) → ³H₅.

Moreover, it is possible to vary the oscillation wavelength continuously around the wavelength range of 750-960nm, by using transition of (³P₁, 3P₀) → ¹G₄.

In the vicinity of a wavelength of 590nm, there exists the ground level absorption (³H₄ → ¹D₂). Therefore, laser oscillation is difficult in the vicinity of this wavelength.

In the vicinity of a wavelength of 800nm, there exists an excited state absorption (¹G₄ → (³P₀, ³P₁ , ³P₂, ¹I₆)). Therefore, in order to obtain laser oscillation in these wavelength bands, it is required to reduce the resonator loss to a very small value.

For example, it is possible to reduce the resonator loss due to absorption and thereby to make the band of the oscillation wavelength wider by using a resonator having a loss lower than or equal to 1%, or by using auxiliary excitation light having a wavelength included in the absorption wavelength (Ar⁺ laser having a wavelength of 467 nm, a wavelength conversion laser having a wavelength of about 580nm, or a semiconductor laser having a wavelength of about 850nm, for example) to suppress the ground level absorption (³H₄- →(¹D₂, ³P₀, ³P₁' ³P₁ , ¹I₆) for example) and the excited state absorption (¹G4 → (³P₀, 3P₁, ³P₂, ¹I₆), for example). By using the above-mentioned techniques, it is possible to constitute a variable wavelength light source capable of scanning the wavelength continuously over the entirety of the wavelength range of about 460nm ∼about 1000nm with the Pr³⁺-doped laser medium.

Moreover, the composition of the fluoride glass used in the present invention may be ZBLAN type, Al-Zr type, or Al type. The ZBLAN type or ZBLAN based fluoride glass is a glass composed mainly of ZrF₄-BaF₂-LaF₃-YF3-AlF₃-NaF -REF₃ (where RE represents a rare earth element). The Al-Zr type or Al-Zr based glass is a glass composed of AlF₃-ZrF₄-MgF₂-CaF₂-SrF₂-BaF₂-NaF₂-REF₃ (where RE represents a rare earth element), etc. The Al type or based glass is a glass composed mainly of AlF₃ -BaF₂-CaF₂-MgF₂ -SrF2-YF₃- REF₃ (where RE represents a rare earth element). ZBLAN type is suitable for highly efficient laser oscillation. The use of Al-Zr type or Al type is desirable when the laser medium is needed to be disposed in the environment in which importance is given to the durability of the glass.

Furthermore, it is possible to generate pulsed light by disposing a dispersion compensation or compensating element in the optical path between the above-mentioned laser medium and the second mirror. The dispersion compensation element used in this invention is a device for providing unequal, delays to different wavelengths, and the dispersion compensation device is composed of wavelength selecting means, etc. As the dispersion compensation device, it is possible to employ prism, grating, fiber grating (called chirped fiber grating especially when used for the dispersion compensation), dispersion compensating mirror, and/or photonic crystalline fiber. For example, it is possible to generate pulsed light by providing a second wavelength selecting means as the dispersion compensation element, in addition to the first wavelength selecting means included in the example of FIG. 1.

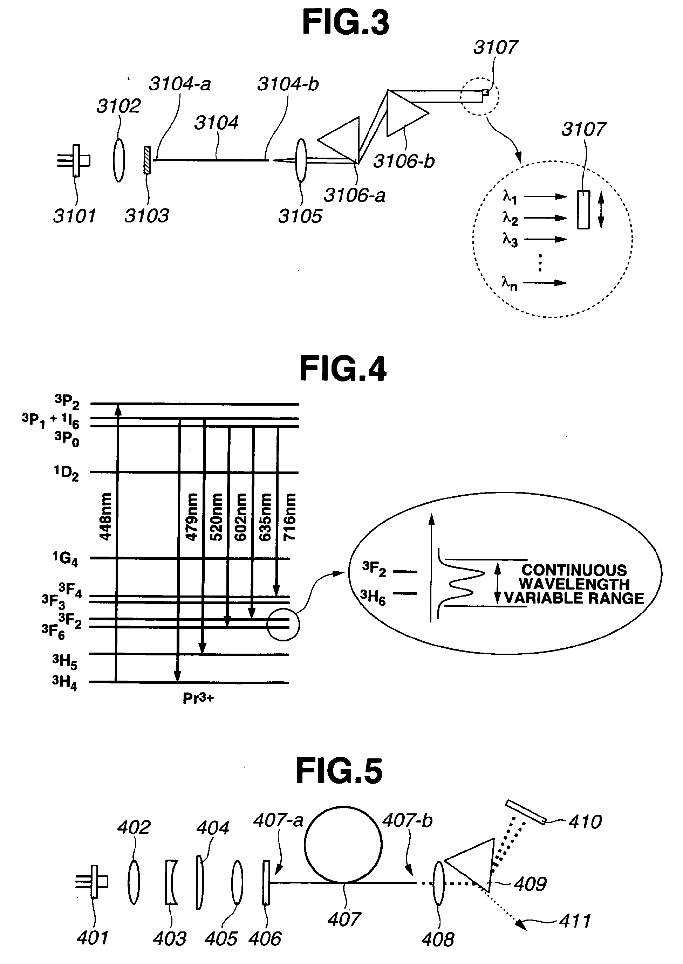

FIG. 3 shows a specific example. The system of FIG. 3 includes an excitation light source 3101, a condensing lens 3102, an excitation light transmission/laser light reflection filter 3103, a rare earth doped fluoride glass fiber 3104, a collimator lens 3105, a prism pair of a prism 3106-a and a prism 3106-b, and a movable mirror 3107. The excitation light irradiated from excitation light source 3101 is condensed by condensing lens 3102, and coupled to the rare earth doped laser fiber 3104. A excitation light source side fiber end 31 04-a on the excitation light source side is polished perpendicularly so as to form a right angle, and attached tightly to a surface of the excitation light transmission/laser light reflection filter 3103. A fiber end 3104-b on the opposite side opposite to the excitation light source side is polished obliquely so as to form an angle greater than or equal to 8° to suppress Fresnel reflection. The excitation light passes through the excitation light transmission/laser light reflection filter 3103 losslessly. A spontaneous emission light (ASE) generated in the fiber 3104 is collimated by collimating lens 3105, caused to pass through the prism pair of prism 3106-a and prism 31 06-b, and then reflected by movable mirror 3107. The generated ASE light bounds back and forth in a resonator formed by the excitation light transmission/laser light reflection filter 3103 and movable mirror 3107, and thereby induce laser oscillation.

In general, when light waves of different wavelengths propagate in fiber, the propagation speeds of waves of different wavelengths differ (called wavelength dispersion) in dependence on the waveguide structure and material. Therefore, when the first wavelength selecting means is disposed in the resonator, it is possible to produce short pulses in time by setting, in the resonator, a dispersion compensation device for correcting wavelength dispersion in the whole of the resonator. In the example shown in FIG. 3, there is additionally provided a second wavelength selecting means in the form of a prism as the dispersion compensation device or element. The first wavelength selecting means and the second wavelength selecting means are disposed in the resonator, in the form of the prism pair (of prism 3106-a and prism 3106-b), and this configuration can generate short pulsed light. Part of the pulsed light is transmitted through the movable mirror 3107, as an output.

In the case of obtaining an output of laser, it is optional to enable partial transmission by lowering the reflectivity at the laser wavelength, of the excitation light transmission/laser light reflection filter 3103 or movable mirror 3107, or to interpose a tap filter in optical paths in the resonator.

As the method for varying the oscillation wavelength of the pulsed light, there is a following example. The light reaching the movable mirror 3107 is dispersed by the prism. Therefore, by using the movable mirror smaller in size than the beam size of the dispersed light as shown in FIG. 3, and shifting the position of the movable mirror 3107 in a direction perpendicular to the optical axis of the laser, it is possible to reflect only light in a desired wavelength band. In this way, the system can vary the oscillation wavelength of the pulsed light.

However, the size of movable mirror 3107 is not limited. For example, even in the case using the movable mirror 3107 having the size larger than the beam size of the dispersed light, it is possible to vary the oscillation wavelength of the pulsed light by interposing a slit between the prism 3106-b and the movable mirror 3107, and allowing transmission of only light of a desired wavelength band of the dispersed light. As another option, it is possible to vary the oscillation wavelength of the pulsed light by interposing a spatial modulating device such as a liquid crystal spatial modulator), and by limiting light in a wavelength region or by varying the transmittance of each wavelength. As still another option, it is possible to vary the oscillation wavelength of the pulsed light by interposing the above-mentioned slit or the spatial modulating device between the prism 31 06-a and the prism 3106-b.

Furthermore, when there is no need for varying the oscillation wavelength of the pulsed light, it is possible to set the size of movable mirror 3107 to an arbitrary value.

Instead of adding a prism as the dispersion compensation element, it is optional, for example, to use a mirror serving also as a dispersion compensating mirror for the excitation light transmission/laser light reflection filter 3103 or movable mirror 3107. Alternatively, the excitation light transmission/laser light reflection filter 3103 or movable mirror 3107 may be replaced by a chirped fiber grating. Moreover, photonic crystalline fiber may be included somewhere in the resonator.

When high quality short pulsed light is desired, it is optional to dispose a saturable absorber in the resonator. When the light power density at the saturable absorber is adjusted, it is optional to interpose a lens and to condense light on the saturable absorber.

Moreover, it is optional to interpose a modulating device such as acousto-optic device when modulation of the repetition frequency of the pulsed light is desired.

The following is detailed examination with reference to practical examples. However, the present invention is not limited to the practical examples.

### PRACTICAL EXAMPLE 1

FIG. 4 shows a level diagram of Pr³+. The energy difference between lower levels of transitions ³P₀→³F₂, and ³P₀ →³H₆ in the form of orange ~ red emission is about 860cm⁻¹. Since the fluoride glass is greater in level splitting as compared to the silica glass, two adjacent levels (³F₂, ³H₆) are overlapped and continuous with each other. A wavelength-variable laser apparatus or tunable laser apparatus is constructed as shown in FIG. 5 to use the transition of ³P₀→(³F₂, ³H₆) for continuous variation of wavelength.

The wavelength-variable laser apparatus shown in FIG. 5 uses, as the excitation light source, a GaN laser diode 401 (central wavelength 448nm: NICHIA Kagaku Kogyo (NICHIA Corporation)), and includes an aspheric lens 402 (NA 0. 60), a cylindrical lens 403 (f=-25mm), a cylindrical lens 404 (f=50mm), an aspherical lens 405 (NA 0. 30), a filter 406 (AR: 448nm, HR: 550∼650nm,), a Pr³⁺-doped fluoride fiber 407 (host glass: ZBLAN glass, Pr³+: 3000ppm, NA: 0.22, core diameter: 3.2µm, fiber length 9cm), an aspheric lens 408 (NA 0.55), a triangular prism 409, and a mirror 410 (HR: 530∼700nm, A resonator is formed between filter 406 and mirror 410.

An AR coating is applied at a wavelength of 448 nm to the optical components (402, 403, 404, 405, 406) through which the excitation light passes. An AR coating is applied at a wavelength of 500~650nm to the optical components (408, 409) through which the laser light passes. The transmission loss of the resonator in the wavelength-variable laser apparatus was 0.8 dB (round trip). A excitation light source side fiber end 407-a on the excitation light source side is polished perpendicularly so as to form a right angle, and attached tightly to a surface of the filter 406. A fiber end 407-b on the opposite side opposite to the excitation light source side is polished obliquely at an angle of 8° to suppress Fresnel reflection. Part of the oscillating laser light is reflected by the surface of the prism. The output is monitored by measuring the reflected light 41 with an optical spectrum analyzer (ANDO AQ6315A).

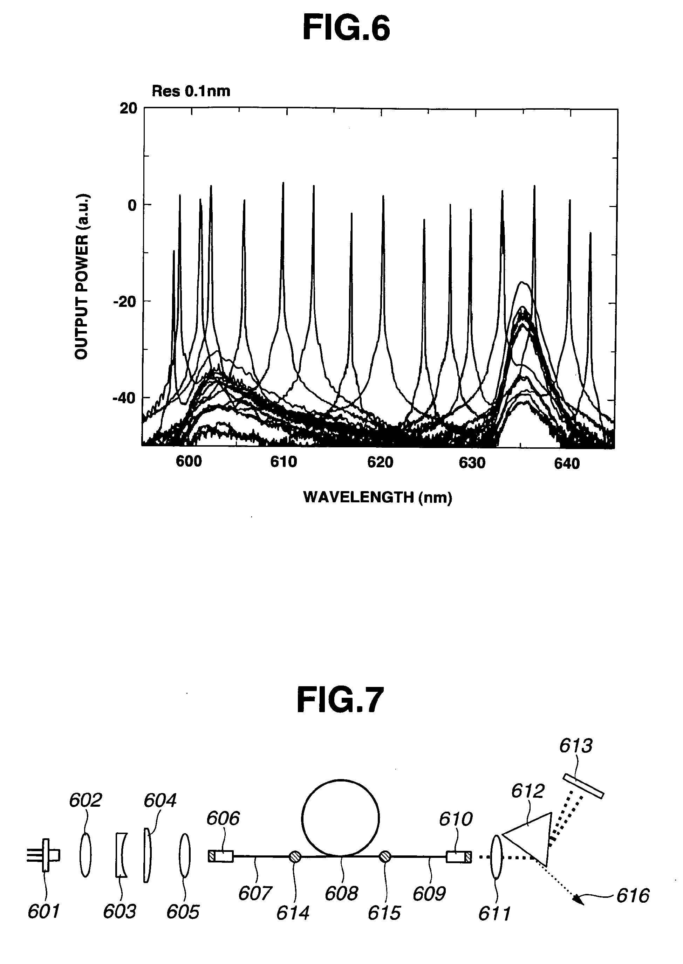

FIG. 6 shows oscillation spectrum of the output monitored when the excitation light of an output of 164mW is inputted to the fiber 407, and the oscillation wavelength is varied by rotating the mirror 410 so as to vary the incident angle and the reflection angle. Laser oscillation was confirmed even in the band of 620~630nm where the gain is small (the band which can be regarded as a region in which two lower levels are overlapped). As a result, the laser oscillation was confirmed over the entirety of the wavelength range of 598.25~642.25nm (the wavelength width 44nm).

When the thus-constructed wavelength-variable light source and nonlinear optical crystal are combined to obtain a second harmonic generation, it is possible to obtain an UV wavelength-variable light source of the wavelength range of 299.13∼321.13 nm (the wavelength width 22nm) in the UV region. Furthermore, by sum frequency mixing of the UV wavelength variable light source and a laser of 488nm (for example, argon ion laser or DPSS laser), it is possible to obtain a wavelength range of 185.5∼193.7 nm (wavelength width). The thus-obtained light source can provide a wavelength (193.3nm) of ArF laser.

### PRACTICAL EXAMPLE 2

FIG. 7 shows a second practical example of the wavelength-variable laser apparatus according to the present invention. The wavelength-variable laser apparatus shown in FIG. 7 uses, as the excitation light source, a GaN laser diode 601 (central wavelength 448nm: NICHIA Kagaku Kogyo (NICHIA Corporation)), and includes an aspheric lens 602 (NA 0. 60), a cylindrical lens 603 (f=-25mm), a cylindrical lens 604 (f=50mm), an aspherical lens 605 (NA 0. 30), a ferrule 606 provided with dielectric multilayer film (AR: 448nm, HR: 550∼650nm,) a Pr³⁺-doped fluoride fiber 608 (host glass: ZBLAN glass, Pr³+: 3000ppm, NA: 0.22, core diameter: 3.2µm, fiber length 9cm) including both ends connected, respectively, with silica fibers 607 and 609 (NA: 0.22, core diameter: 3.2µm), a ferrule 610 provided with an antireflection film (AR: 510∼720nm ), an aspheric lens 611 (NA 0.55), a triangular prism 612, and a mirror 613 (HR: 530~700nm). A resonator is formed between ferrule 606 provided with dielectric multilayer film and mirror 613.

An AR coating is applied at a wavelength of 448 nm to the optical components (602, 603, 604, 605) through which the excitation light passes. An AR coating is applied at a wavelength of 510∼700 nm to the optical components (611, 612) through which the laser light passes. The connection loss between the silica fiber and fluoride fiber was 0.3dB for each connection point at a wavelength of 635nm. An excitation side silica fiber end is connected with the dielectric multilayer coated ferrule 606 (AR: 448nm, HR: 550~650nm) allowing the excitation light to pass through without loss and reflecting the laser light. The opposite silica fiber end is connected with the antireflective coated ferrule 610 (AR: 510∼720nm) allowing the laser light to pass through without loss. Part of the oscillating laser light is reflected by the surface of the prism. The output is monitored by measuring the reflected light 616 with an optical spectrum analyzer (ANDO AQ6315A).

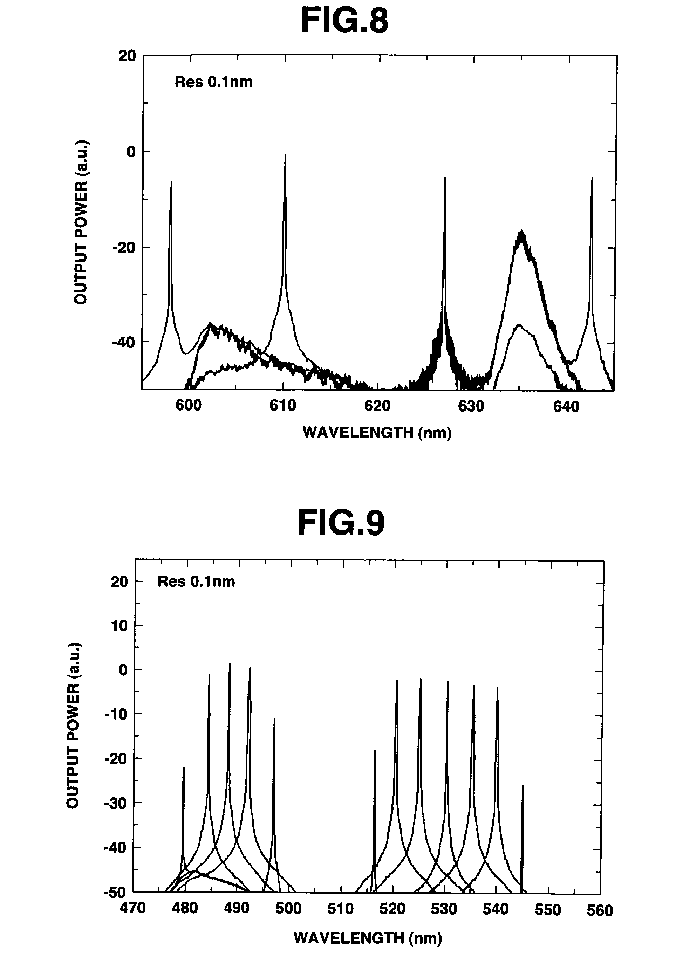

FIG. 8 shows oscillation spectrum of the output monitored when the excitation light of an output of 190mW is inputted to the fiber 607, and the oscillation wavelength is varied by rotating the mirror 613 so as to vary the incident angle and the reflection angle. Laser oscillation was confirmed over the entirety of the wavelength range of 598.25∼642.25nm (the wavelength width 44nm).

### PRACTICAL EXAMPLE 3

This practical example is similar in construction to the first practical example except that the filter 406 is replaced by a filter which is high in reflectivity in a region of blue-green. That is, as shown in FIG. 5, the wavelength-variable laser apparatus uses, as the excitation light source, a GaN laser diode 401 (central wavelength 448nm: NICHIA Kagaku Kogyo (NICHIA Corporation)), and includes an aspheric lens 402 (NA 0. 60), a cylindrical lens 403 (f=-25mm), a cylindrical lens 404 (f=50mm), an aspherical lens 405 (NA 0. 30), a filter 406 (AR: 448nm, HR: 475∼500nm and 515~550nm), a Pr³⁺-doped fluoride fiber 407 (host glass: ZBLAN glass, Pr³⁺: 3000ppm, NA: 0.22, core diameter: 3.2µm, fiber length 9cm), an aspheric lens 408 (NA 0.55), a triangular prism 409, and a mirror 410 (HR: 400∼1100nm). A resonator is formed between filter 406 and mirror 410.

An AR coating is applied at a wavelength of 448 nm to the optical components (402, 403, 404, 405, 406) through which the excitation light passes. An AR coating is applied at a wavelength of 470∼960nm to the optical components (408, 409) through which the laser light passes. The transmission loss of the resonator in the wavelength-variable laser apparatus was 0.8 dB (round trip). A excitation light source side fiber end 407-a on the excitation light source side is polished perpendicularly so as to form a right angle, and attached tightly to the filter 406. A fiber end 407-b on the opposite side opposite to the excitation light source side is polished obliquely at an angle of 8° to suppress Fresnel reflection. Part of the oscillating laser light is reflected by the surface of the prism. The output is monitored by measuring the reflected light 41 with the optical spectrum analyzer (ANDO AQ6315A).

FIG. 9 shows oscillation spectrum of the output monitored when the excitation light of an output of 200mW is inputted to the fiber 407, and the oscillation wavelength is varied by rotating the mirror 410 so as to vary the incident angle and the reflection angle. In the blue region, it was possible to vary the laser oscillation wavelength continuously over a range of 478∼498nm. In the green region, it was possible to vary the laser oscillation wavelength continuously over a range of 514∼548nm.

### PRACTICAL EXAMPLE 4

This practical example is similar in construction to the first practical example except that the filter 406 and mirror 410 are replaced by units having wide band property and a high reflectivity. That is, as shown in FIG. 5, the wavelength-variable laser apparatus uses, as the excitation light source, a GaN laser diode 401 (central wavelength 448nm: NICHIA Kagaku Kogyo (NICHIA Corporation)), and includes an aspheric lens 402 (NA 0. 60), a cylindrical lens 403 (f=-25mm), a cylindrical lens 404 (f=50mm), an aspherical lens 405 (NA 0. 30), a filter 406 (AR: 448nm, HR: 550-730nm), a Pr³+-doped fluoride fiber 407 (host glass: ZBLAN glass, Pr³+: 3000ppm, NA: 0.22, core diameter: 3.2µm, fiber length 9cm), an aspheric lens 408 (NA 0.55), a triangular prism 409, and a mirror 41 0 (HR: 400∼1100nm). A resonator is formed between filter 406 and mirror 410.

An AR coating is applied at a wavelength of 448 nm to the optical components (402, 403, 404, 405, 406) through which the excitation light passes. An AR coating is applied at a wavelength of 470∼960nm to the optical components (408, 409) through which the laser light passes. The transmission loss of the resonator in the wavelength variable laser apparatus was 0.8 dB (round trip). A excitation light source side fiber end 407-a on the excitation light source side is polished perpendicularly so as to form a right angle, and attached tightly to filter 406. A fiber end 407-b on the opposite side opposite to the excitation light source side is polished at an angle of 8° to suppress Fresnel reflection. Part of the oscillating laser light is reflected by the surface of the prism. The output is monitored by measuring the reflected light 411 with the optical spectrum analyzer (ANDO AQ6315A).

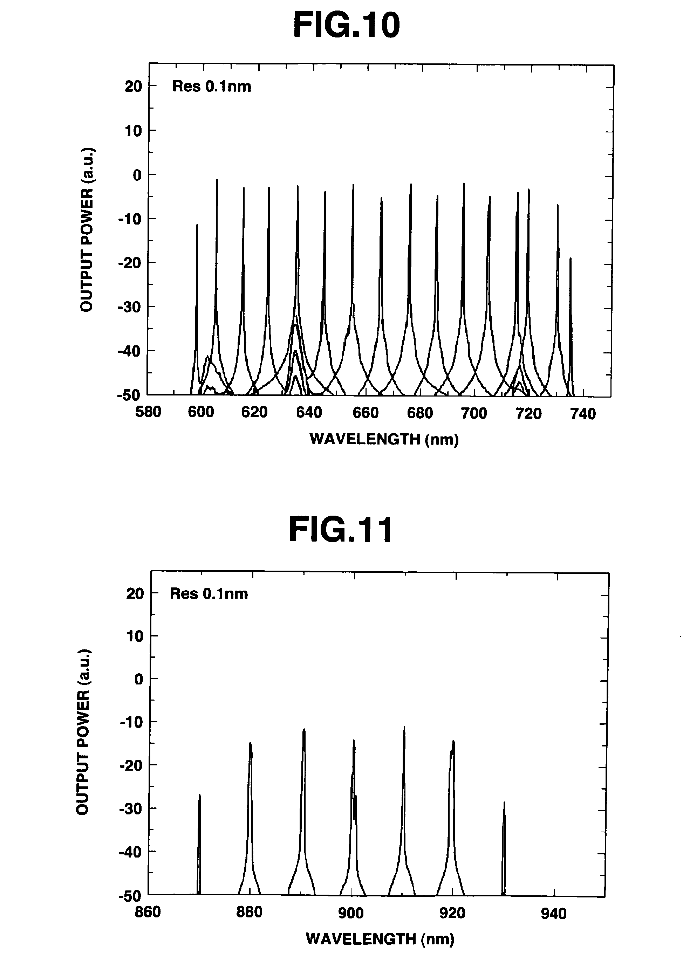

FIG. 10 shows oscillation spectrum of the output monitored when the excitation light of an output of 200mW is inputted to the fiber 407, and the oscillation wavelength is varied by rotating the mirror 410 so as to vary the incident angle and the reflection angle. It was possible to vary the laser oscillation wavelength continuously over the range of 596∼736nm.

### PRACTICAL EXAMPLE 5

This practical example is similar in construction to the first practical example except that the filter 406 and mirror 410 are replaced by units which are high in reflectivity in the infrared region. That is, as shown in FIG. 5, the wavelength-variable laser apparatus uses, as the excitation light source, a GaN laser diode 401 (central wavelength 448nm: NICHIA Kagaku Kogyo (NICHIA Corporation)), and includes an aspheric lens 402 (NA 0. 60), a cylindrical lens 403 (f=-25mm), a cylindrical lens 404 (f=50mm), an aspherical lens 405 (NA 0. 30), a filter 406 (AR: 448nm, HR: 860-960nm), a Pr³+-doped fluoride fiber 407 (host glass: ZBLAN glass, Pr³⁺: 3000ppm, NA: 0.22, core diameter: 3.2µm, fiber length 9cm), an aspheric lens 408 (NA 0.55), a triangular prism 409, and a mirror 410 (HR: 400∼1100nm). A resonator is formed between filter 406 and mirror 410.

An AR coating is applied at a wavelength of 448 nm to the optical components (402, 403, 404, 405, 406) through which the excitation light passes. An AR coating is applied at a wavelength of 470∼960nm to the optical components (408, 409) through which the laser light passes. The transmission loss of the resonator in the wavelength- variable laser apparatus was 0.8 dB (round trip). A excitation light source side fiber end 407-a on the excitation light source side is polished perpendicularly so as to form a right angle, and attached tightly to filter 406. A fiber end 407-b on the opposite side opposite to the excitation light source side is polished at an angle of 8° to suppress Fresnel reflection. Part of the oscillating laser light is reflected by the surface of the prism. The output is monitored by measuring the reflected light 411with the optical spectrum analyzer (ANDO AQ6315A).

FIG. 11 shows oscillation spectrum of the output monitored when the excitation light of an output of 200mW is inputted to the fiber 407, and the oscillation wavelength is varied by rotating the mirror 410 so as to vary the incident angle and the reflection angle. It was possible to vary the laser oscillation wavelength continuously over the range of 870∼930nm.

When the thus-obtained wavelength-variable light source and a nonlinear optical crystal are combined to obtain a second harmonic wave, it is possible to obtain UV wavelength-variable light source or light sources of a wavelength range of 239∼249nm (wavelength width 11 nm), a wavelength range of 257∼274nm, (wavelength width 1 8nm), a wavelength range of 298∼368nm (wavelength width 71 nm), and a wavelength range of 435∼465nm, (wavelength width 31 nm) in the UV region. Thus, it is possible to obtain wavelengths of N2 laser (337nm), part of the wavelength range of Ce:LiSAF laser (285~299nm), XeF laser (351 nm), XeCl laser (308nm), KrF laser (248nm) etc.

Furthermore, by sum frequency mixing of the UV wavelength- variable light source obtained by the second harmonic wave of the light source according to the present invention, for example, with a laser of 488nm (such as argon ion laser or DPSS laser), it is possible to obtain wavelength ranges of 160.4∼164.9nm, 168.3∼1 75.5nm, 185.0∼209.8nm, and 230.0∼238.1 nm. With the thus-obtained light source, it is possible to obtain wavelengths of Xe₂ excimer laser (172nm) and ArF laser (193.3nm).

Furthermore, by sum frequency mixing of the UV wavelength-variable light source obtained by the second harmonic wave of the light source according to the present invention, for example, with a laser of 405nm (such as GaN type semiconductor laser), it is possible to obtain wavelength ranges of 150.3∼154.2nm, 157∼2-163.4nm, 171.7∼192.8nm and 209.7∼216.5nm. With the thus-obtained light source, it is possible to obtain wavelength of F2 laser (158nm).

Furthermore, with a combination of laser light sources having different wavelengths obtained according to the present invention, it is possible to obtain a laser of a new wavelength band, by sum frequency · difference frequency generation.

In the above practical examples 1∼5, the laser medium is in the form having fiber structure. However, this is not a limiting condition imposing limitation. Instead of the fiber structure, it is optional to employ a configuration including a waveguide structure, or a configuration of a bulk form made of Pr³+-doped fluoride glass. Moreover, needless to say, the laser oscillation wavelength range is further widened when the loss of the resonator is reduced or the excitation power is increased.

### PRACTICAL EXAMPLE 6

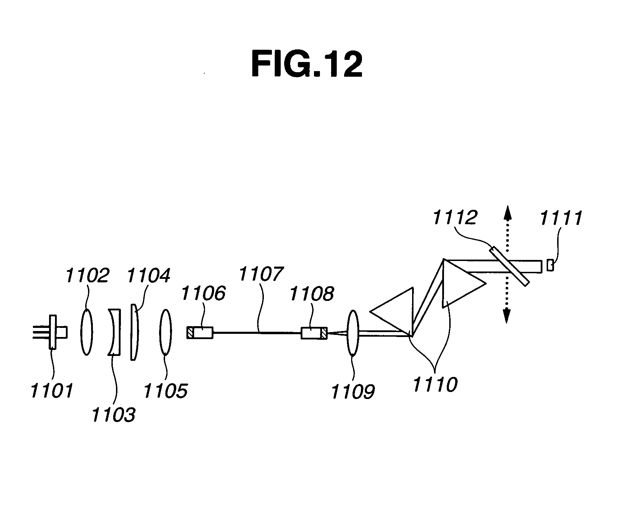

FIG. 12 shows wavelength-variable laser apparatus generating pulsed light. The wavelength-variable laser apparatus shown in FIG. 12 uses, as the excitation light source, a GaN laser diode 1101 (central wavelength 448nm: NICHIA Kagaku Kogyo (NICHIA Corporation)), and includes an aspheric lens 1102 (NA 0. 60), a cylindrical lens 1103 (f=-25mm), a cylindrical lens 1104 (f=50mm), an aspherical lens 1105 (NA 0. 30), a ferrule 1106 provided with dielectric multilayer film (AR: 448nm, HR: 550∼720nm), a Pr³+-doped fluoride fiber 1107 (host glass: ZBLAN glass, Pr³+: 3000ppm, NA: 0.22, core diameter: 3.8 µm, fiber length 9cm), a ferrule 1108 provided with an antireflection film (AR: 50∼720nm ), an aspheric lens 1109 (NA 0.55), a pair of triangular prisms 1110, a beam splitter 1112 (transmission 93%, reflection 7%) and a movable mirror 1111 having a surface coated with a dye (rhodamine 640). A resonator is formed between ferrule 1106 provided with dielectric multilayer film and movable mirror 1111.

Since dye is significant in fading, the movable mirror 1111 was used while being rotated. Among two beams of light reflected by beam splitter 1112, one was inputted to an autocorrelator (Mini produced by APE GmbH) and used for pulse duration measurement, and the other beam was used for power measurement and wavelength measurement. An AR coating is applied at a wavelength of 448 nm to the optical components (1102, 1103, 1104, 1105) through which the excitation light passes. An AR coating is applied at a wavelength of 50∼720nm to the optical component (1109) through which the laser light passes. The wavelength dispersion of fluoride fiber 1107 used in this practical example is -240ps/km/nm at a wavelength of 635nm, and this wavelength dispersion is compensated for by using the pair of triangular prisms 1110.

By measuring one of the reflected beams of beam splitter 1112 with the optical spectrum analyzer (ANDO AQ631 5A), laser oscillation was confirmed around a wavelength of 635nm. By measuring the other reflected beam with the autocorrelator simultaneously, the pulse duration or width was 13ps.

Then, when the position of movable mirror 1111 was change, laser output was obtained in the vicinity of wavelength of 716nm, and the pulse duration at that time was 10ps.

If use is made of a saturable absorber manufactured more accurately and/or a dispersion compensating device, it is possible to obtain short pulsed light (short in terms of time).

Although the prism is used as the dispersion compensating device here, it is possible to use fiber Bragg grating, dispersion compensating mirror, or photonic crystalline fiber.

The fiber used in each of the practical examples 1∼6 is a multi-mode fiber at a laser oscillation wavelength band. However, it is optional to use a single mode fiber.

### INDUSTRIAL APPLICABILITY

The present invention can be utilized as a wide band wavelength-variable or tunable light source in the visible light region. Moreover, since the wide band wavelength-variable light source is feasible in the visible light region, in the case of forming a wavelength-variable light source in the UV region using the wavelength conversion technique, the number of wavelength conversions can be reduced compared with a UV region wavelength-variable light source based on wavelength conversion using infrared laser as the fundamental wave, and hence it is possible to improve the efficiency and widen the variable wavelength range.

Therefore, in a wavelength-variable UV light source usable also in the field of lithography, it is possible to utilize as the light source of the fundamental wave. Furthermore, in the field of display projection, it is possible to use as a light source superior in color reproducibility since the a light source of any wavelength in the blue region and green region can be obtained according to the present invention.

Moreover, the present invention can be utilized as a pulsed light source, and specifically, the present invention is utilizable in the field of processing or working (especially, forming of transparent material such as plastics).

### EXPLANATION OF REFERENCE NUMERALS

101,3101: excitation light source
102, 3102: condensing lens
103, 3103: excitation light transmission/laser light reflection filter
104, 3104: rare earth doped fluoride glass fiber
104-a, 3104-a: end face of the rare earth doped fluoride glass fiber on the excitation light source side
104-b, 3104-b: end face of the rare earth doped fluoride glass fiber on the opposite side opposite to the excitation light source side
105, 3105: collimator or collimating lens
106, 3106-a, 3106-b: prism
107, 3107, 1111: movable mirror
201: ground level of rare earth ion
202: lower level in laser oscillation
203: lower level adjacent to level 202 in laser oscillation
204: upper level in laser oscillation
401, 601, 1101: GaN laser diode
402, 602, 1102: aspherical lens
403, 603, 1103: cylindrical lens
404, 604, 1104: cylindrical lens
405, 605, 1105, 1109: aspherical lens
406: filter
407, 608, 1107: Pr³⁺-doped fluoride fiber
407-a: end face of Pr³⁺-doped fluoride glass fiber on the excitation light source side
407-b: end face of Pr³⁺-doped fluoride glass fiber on the side opposite to the excitation light source side
408, 611: aspherical lens
409, 612, 1110: triangular prism
410,613: mirror
411, 616: reflected light from prism surface
606, 1106: ferrule provided with dielectric multilayer film
607, 609: silica or quartz fiber
610, 1108: ferrule provided with antireflection film
614, 615: connection point between silica fiber and fluoride fiber
1112: beam splitter

## Claims

1. In a laser apparatus comprising:
an excitation light source comprising a GaN based laser diode having a wavelength range of 420∼475nm; and
a resonator comprising a laser medium configured to emit light by excitation light from the excitation light source and disposed in the optical path between a first mirror allowing transmission of excitation light from the excitation light source and reflecting light in a desired wavelength band excluding the excitation light and a second mirror reflecting light in a desired wavelength band, and a first wavelength selecting means disposed in the optical path between the laser medium and the second mirror;
a wavelength-variable laser apparatus **characterized in that** the wavelength-variable laser apparatus is capable of varying a laser oscillation wavelength continuously by using at least a Pr³⁺-doped fluoride glass as the laser medium.

2. The wavelength-variable laser apparatus as claimed in Claim 1 , wherein the first wavelength selecting means includes one of a prism, an etalon, a birefringent filter, a dielectric multilayer filter and a grating.

3. The wave-length variable apparatus as claimed in Claim 1 , wherein the laser medium forms a core of an optical waveguide.

4. The wavelength-variable laser apparatus as claimed in Claim 3, wherein both ends of the laser medium are connected, respectively, with optical waveguides comprising silica-based glass.

5. The wavelength-variable laser apparatus as claimed in one of Claims 1∼4, wherein pulsed light is generated by disposing a dispersion compensating device for compensating for wavelength dispersion of the whole of the resonator, in the optical path between the laser medium and the second mirror.

6. The wavelength-variable laser apparatus as claimed in Claim 5, wherein the dispersion compensating device is a second wavelength selecting means paired with the first wavelength selecting means.
